# FASCICULE DE BREVET EUROPEEN

(11) **EP 2 203 939 B1**
(45) Date de publication et mention de la délivrance du brevet: **19.10.2016**
(21) Numéro de dépôt: 08869350.2
(22) Date de dépôt: 22.10.2008
(51) Int. Cl.: H01L 29/06, H01L 33/00, H01L 33/08, H01L 33/16, H01L 33/38, B82B 3/00, H01S 5/34, H01S 5/42, B82Y 10/00, B82Y 20/00

(54) **DISPOSITIF OPTOELECTRONIQUE A BASE DE NANOFILS ET PROCEDES CORRESPONDANTS**
OPTOELEKTRONISCHE ANORDNUNG MIT NANODRÄHTEN UND ENTSPRECHENDE VERFAHREN
OPTOELECTRONIC DEVICE INCLUDING NANOWIRES, AND CORRESPONDING METHODS

(30) Priorité: 22.10.2007 FR 0707385
(43) Date de publication de la demande: 07.07.2010
(73) Titulaire: Commissariat à l'Énergie Atomique et aux Énergies Alternatives, 75015 Paris (FR)
(72) Inventeur: GILET, Philippe, 38470 Têche (FR); GRENOUILLET, Laurent, F-38140 Rives (FR)
(74) Mandataire: Gevers & Orès
(86) Numéro de dépôt international: PCT/FR2008/001484
(87) Numéro de publication internationale: WO 2009/087319

(56) Documents cités:
- US-A1- 2005 253 138
- US-A1- 2007 057 248

## Description

L'invention concerne le domaine de l'optoélectronique et en particulier, les émetteurs de rayonnement utilisant des semi-conducteurs et les photorécepteurs.

De façon classique, les dispositifs optoélectroniques tels que les dispositifs émetteurs de lumière de type LED (Light Emitting Diode) ou lasers, sont obtenus par épitaxies successives de différents matériaux semi-conducteurs.

Ainsi, la famille de matériaux III-N (GaN, AlN...) présente de bonnes caractéristiques physiques pour la réalisation de diodes électroluminescentes pour des longueurs d'ondes allant du proche UV jusqu'au vert.

Ces matériaux posent cependant un problème majeur.

En effet, il n'existe pas de substrat adapté, en termes de paramètres de maille, de densité de défauts et de taille, permettant de faire croître des couches planaires présentant de bonnes qualités cristallines. Compte tenu de l'indice de réfraction élevé des semi-conducteurs, lequel est compris entre 2 et 3,5, une part importante de la lumière émise au sein du matériau ne peut donc pas en sortir.

De façon classique, ces effets néfastes peuvent être réduits en rendant la surface de la diode rugueuse.

Cependant, depuis quelques années, l'apparition d'une nouvelle structure de matériau permet de résoudre ce problème. Il s'agit des nanofils qui sont des semi-conducteurs dont la dimension transversale est de taille nanométrique. Ainsi, le diamètre typique d'un nanofil est de quelques dizaines à quelques centaines de nanomètres, tandis que sa hauteur totale est de l'ordre du micron.

Ces nanofils peuvent être réalisés sur des substrats dont le paramètre de maille est largement différent et ils peuvent également améliorer l'extraction de la lumière.

Il est ainsi possible de réaliser des nanofils avec de bonnes propriétés structurales et physiques.

En ce qui concerne l'extraction de lumière, chaque nanofil peut être considéré comme un guidé d'ondes. Compte tenu de sa forme quasi cylindrique, de sa taille et de son indicé de réfraction (plus grand que le milieu ambiant), le guidage de la lumière est réalisé sensiblement parallèlement à l'axe de croissance des nanofils. La lumière arrive ainsi à l'extrémité des nanofils avec un angle faible par rapport à l'axe de celui-ci, c'est-à-dire un angle inférieur à l'angle limite de réflexion totale, ce qui facilite la sortie de la lumière. C'est pourquoi, ont déjà été réalisés des composants optoélectroniques, par exemple LED ou diode laser, mettant en oeuvre des nanofils.

Lorsque les nanofils sont conçus pour émettre de la lumière et non seulement la guider, ils comportent une jonction pn.

Les procédés mis en oeuvre consistent tout d'abord à obtenir des nanofils sur un substrat. Ces procédés sont largement décrits dans l'état de la technique. On peut notamment se référer au document WO 2004/088755 qui fait référence au processus VLS (Vapor Liquid Solid).

Ils peuvent par exemple être réalisés à base de matériaux issus d'une famille III-N, GaAs, ZnO, InP, sur un substrat par exemple en silicium ou saphir.

Le procédé consiste alors à remplir les interstices entre les nanofils par le dépôt d'une couche de matériau diélectrique, isolant électriquement, par exemple de type SiO₂, dont l'épaisseur est supérieure à la hauteur des nanofils. Le matériau doit bien remplir les interstices.

L'étape suivante consiste à planariser cette couche, tout en éliminant le surplus de matériau diélectrique au dessus des nanofils. Est ainsi

obtenue une surface plane, l'extrémité supérieure des nanofils affleurent la surface.

Si le matériau déposé est un planarisant, l'étape de planarisation est omise.
Une autre étape consiste alors à déposer sur cette surface plane une couche semi-transparente conductrice qui vient en contact avec la face supérieure des nanofils. Cette couche est classiquement réalisée en ITO (Indium Tin Oxide). Après dépôt de cette couche d'ITO sur toute la surface, des motifs géométriques sont définis par des techniques classiques de microélectronique de type photolithographie. Enfin, des contacts électriques sont réalisés, un au niveau du substrat, et l'autre au niveau de la couche semi- transparente conductrice. Le document US 2005/0253138 concerne un procédé de fabrication d'un dispositif optoélectronique à base de nanofils en silicium, dans lequel les nanofils (20) sont recouverts d'une gaine isolante (22), la face supérieure des nanofils (20) étant en contact électrique avec une électrode (40) semi-transparente.

On peut notamment se référer à l'article suivant :"High-Brightness Light Emitting Diodes Using Dislocation-Free Indium Gallium Nitride/Gallium Nitride Multiquantum-Well Nanorod Array", NANO LETTERS, 2004, Vol.4, No.6, 1059-1062".

Ce procédé permet d'obtenir un composant de type LED ou diode laser, dans lequel l'émission de lumière s'effectue au travers de la couche semi-transparente.

Cependant, la présence de cette couche semi-transparente présente des inconvénients importants.

En effet, il convient qu'elle soit la plus conductrice possible.

Or, la plupart des matériaux présentant une bonne conductivité électrique absorbent la lumière. Par ailleurs, cette couche doit être également fortement transparente pour permettre une bonne extraction de lumière.

En conséquence, les caractéristiques techniques que doit présenter cette couche étant antinomiques, les matériaux choisis résultent d'un compromis. Ainsi, on retient généralement une couche semi-conductrice et semi-transparente, comme certains oxydes tels ITO ou ZnO, ou encore des matériaux métalliques déposés en fine couche, dont l'épaisseur est inférieure à 5nm.

L'invention a pour objet de pallier ces inconvénients en proposant un procédé de réalisation d'un dispositif optoélectronique à base de semi-conducteurs de type nanofils qui rend inutile la présence d'une couche conductrice semi-transparente recouvrant la surface des nanofils.

Ce procédé permet donc d'obtenir des dispositifs optoélectroniques pour lesquels il n'existe pratiquement pas de déperdition de la lumière émise.

Ainsi, l'invention concerne un procédé de réalisation de dispositifs optoélectroniques, à base de semi-conducteurs de type nanofils.

Ce procédé comporte les étapes suivantes :
- l'obtention de nanofils sur un substrat, au niveau duquel est réalisée une première zone de contact électrique, lesdits nanofils étant susceptibles d'émettre un faisceau lumineux,
- le dépôt d'une couche de matériau pour remplir des interstices entre les nanofils, éventuellement ultérieurement planarisée,

caractérisé en ce qu'il comprend des étapes d'obtention d'une couche d'un matériau conducteur électrique sur le pourtour desdits nanofils et en contact direct avec les nanofils, sur une hauteur h déterminée et au niveau de leur extrémité opposée au dit substrat, ainsi qu'entre lesdits nanofils, la face supérieure desdits nanofils étant à nu, dé manière à former une deuxième zone de contact électrique au niveau des nanofils.

Dans un mode préféré de mise en oeuvre de ce procédé de réalisation, les étapes d'obtention d'une couche d'un matériau conducteur électrique consistent en :
- la gravure de ladite couche de matériau pour mettre à nu l'extrémité supérieure des nanofils sur une hauteur h déterminée,
- le dépôt d'une couche de matériau conducteur électrique sur ladite hauteur h des nanofils,
- le dépôt d'une autre couche d'un matériau pour remplir les interstices entre les nanofils, suivi éventuellement d'une étape de planarisation,
- la gravure de ladite autre couche de matériau pour découvrir la partie supérieure des nanofils,
- la gravure de ladite couche de matériau conducteur électrique pour mettre à nu la face supérieure des nanofils,
- le retrait du matériau conducteur électrique présent sur la face supérieure des nanofils et enfin,
- le retrait de l'autre couche de matériau encore présente sur le matériau conducteur électrique.

Les procédés sont également caractérisés par les caractéristiques supplémentaires suivantes :
- les nanofils sont dopés avec des porteurs appropriés pour assurer une bonne continuité électrique entre le substrat et les nanofils,
- le dopage des nanofils, sur la hauteur h, est réalisé avec des porteurs de conductivité opposée à celle des porteurs présents dans le reste des nanofils,
- le contact entre les nanofils et le substrat est réalisé directement ou indirectement,
- des fils métalliques sont fixés au niveau de chacune desdites zones de contact électrique, et
- une dernière couche de matériau dit phosphorescent est déposée de façon à recouvrir la face supérieure des nanofils.

L'invention concerne aussi un dispositif optoélectronique comportant au moins un semi-conducteur de type nanofil, présentant une structure de type guide d'ondes, et étant susceptible d'émettre un faisceau lumineux, et deux zones de contact électrique, l'une d'elles étant située sur le pourtour dudit au moins un nanofil, en contact direct avec ledit au moins un nanofil et à proximité de l'une de ses extrémités, la face supérieure dudit nanofil ne participant pas au contact électrique.

Ce dispositif est également caractérisé par les caractéristiques additionnelles suivantes :
- la zone de contact électrique située sur le pourtour dudit au moins un nanofil est constituée par une couche d'un matériau conducteur électrique qui laisse à découvert la face supérieure du nanofil,
- le dopage dudit au moins un nanofil, dans la zone de contact électrique située sur son pourtour, est réalisé avec des porteurs de conductivité opposée à celle des porteurs présents dans le reste du nanofil, et
- une couche d'un matériau dit phosphorescent recouvrant la face supérieure dudit au moins un nanofil pour convertir la lumière issue dudit nanofil en lumière dite blanche.

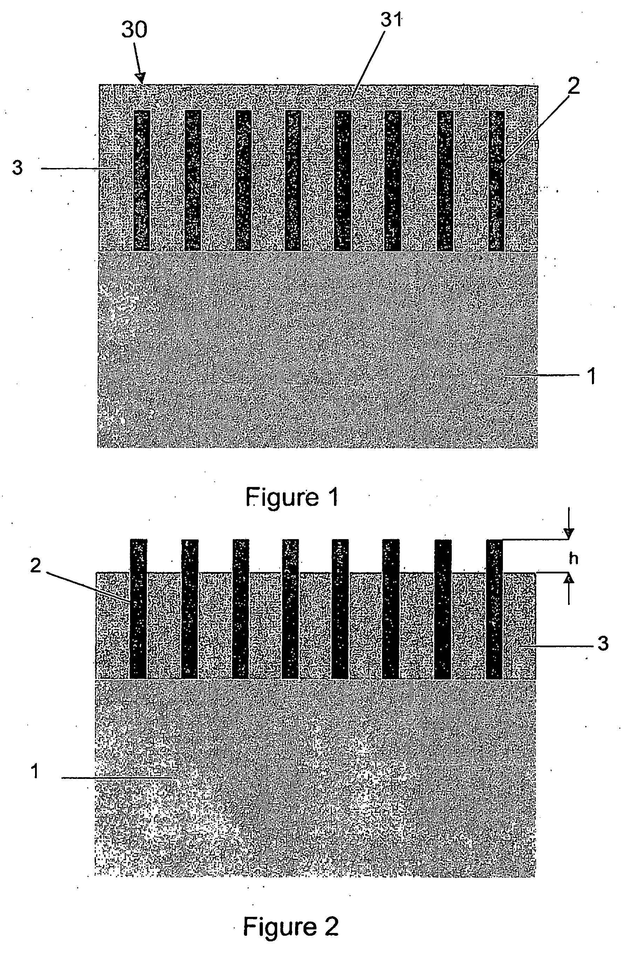

L'invention sera mieux comprise et d'autres buts, avantages et caractéristiques de celle-ci apparaitront plus clairement à la lecture de la description qui suit et qui est faite au regard des dessins annexés, sur lesquels les figures 1 à 10 représentent différentes étapes des procédés selon l'invention permettant l'obtention de dispositifs optoélectroniques, à base de semi-conducteurs de type nanofils.

Les éléments communs aux différentes figures seront désignés par les mêmes références.

Bien entendu, la description qui suit n'est donnée qu'à titre d'exemple et n'est absolument pas limitative.

La première étape de ces procédés consiste à réaliser des nanofils sur un substrat, ces nanofils présentant une structure de type guide d'ondes.

A titre d'exemple, sur un substrat de silicium orienté (111) 1 fortement dopé de type n et donc bon conducteur électrique, des nanofils peuvent être obtenus par tout procédé approprié. Ainsi, des nanofils de la famille de matériaux III-V pourront être obtenus par épitaxie, par jets moléculaires ou par MOCVD (Metal Organic Chemical Vapor Deposition) sans catalyseur.

La densité des nanofils obtenus sera d'environ quelques 10⁸cm⁻² et ils présenteront une hauteur de 3µm pour un diamètre d'environ 300nm.

Lorsque le diamètre des nanofils est suffisamment important, on peut considérer que le champ optique du faisceau lumineux émis par les nanofils est essentiellement confiné à l'intérieur des nanofils. Ainsi, la déperdition du faisceau lumineux émis par les nanofils est très faible.

Pour obtenir cette propriété, il est nécessaire que le diamètre des nanofils soit de l'ordre de grandeur de la longueur d'onde divisée par l'indice de réfraction du nanofil.

Les longueurs d'ondes considérées dans le cadre de la présente invention sont comprises entre 200nm et quelques microns. Il convient donc que les nanofils aient un diamètre supérieur à quelques centaines de nanomètres, compte tenu de l'indice optique du matériau.

Ces nanofils sont conçus pour générer et émettre un faisceau lumineux. Ils comprennent une jonction pn en matériau GaN, au milieu de laquelle seront présents trois puits quantiques d'InGaN. Par une mesure par photoluminescence, ces puits émettent à une longueur d'onde voisine de 450nm.

Les nanofils sont dopés de type n au niveau du substrat, dans cet exemple, de façon à assurer une bonne continuité électrique entre le substrat et les nanofils.

Comme il sera expliqué ultérieurement, au niveau de leur extrémité supérieure, opposée au substrat, les nanofils seront dopés avec des porteurs de type p. Ce dopage sera réalisé sur une hauteur déterminée h qui sera précisée dans la suite de la description.

Enfin, les nanofils pourront être, soit en contact direct avec le substrat de silicium, soit en contact indirect avec celui-ci, une couche d'AlN, dopée avec des porteurs de type n et de faible épaisseur, étant alors intercalée entre le substrat et les nanofils.

L'étape suivante consiste à déposer, sur la plaquette obtenue, une couche de matériau planarisant, de façon à remplir les interstices entre les nanofils.

Le matériau utilisé peut être un polymère planarisant largement utilisé dans le domaine de la microélectronique, par exemple du type BCB ou polyimide.

Dans le cas particulier décrit, le polymère utilisé est le polymère accuflo T27 de la société Honeywell.

Comme l'illustre la figure 1, le matériau planarisant 3 remplit complètement l'espace entre les nanofils 2, tout en présentant sur le dessus une surface 30 plane et lisse.

L'étape suivante, illustrée à la figure 2, consiste en une gravure de la couche de matériau planarisant 3.

De façon connue, on utilise un bâti de gravure de type plasma Barrel ou RIE (Reactive Ion Etching) à base d'oxygène. Les paramètres retenus dépendent bien sûr de l'équipement utilisé.

La vitesse de gravure retenue est typiquement de l'ordre de 50nm/min.

Dans le bâti évoqué plus haut, le plasma d'oxygène créé permet de graver la couche de polymère planarisant de façon uniforme.

En calibrant de façon appropriée la vitesse de gravure bien connue de l'homme de l'art, la couche 3 peut être gravée de façon à éliminer la partie 31 de la couche 3 qui dépasse des nanofils 2. La gravure est ensuite poursuivie pour que l'extrémité supérieure des nanofils débouche de la couche 3, sur une hauteur h déterminée.

Par exemple, cette hauteur h peut être comprise entre 200 et 500nm. C'est sur cette hauteur que les nanofils ont préalablement été dopés avec des porteurs de typé p.

Il convient de souligner que contrairement à ce qu'illustrent les figures 1 et 2, les nanofils réalisés par épitaxie peuvent présenter des longueurs variables.

En conséquence, le procédé de l'état de la technique décrit précédemment ne permettait de réaliser un contact, par l'intermédiaire de la couche semi-transparente conductrice, que pour les nanofils présentant une longueur suffisamment importante. Pour pouvoir réaliser un contact sur l'ensemble des nanofils, une étape préalable de polissage était nécessaire pour réduire la longueur des nanofils les plus longs.

Comme cela apparaîtra dans la suite de la description, l'invention permet de réaliser un contact sur l'ensemble des nanofils, même s'ils présentent des tailles différentes, dans la mesure où la couche de matériau planarisante est gravée de façon suffisamment importante pour dégager l'ensemble des nanofils.

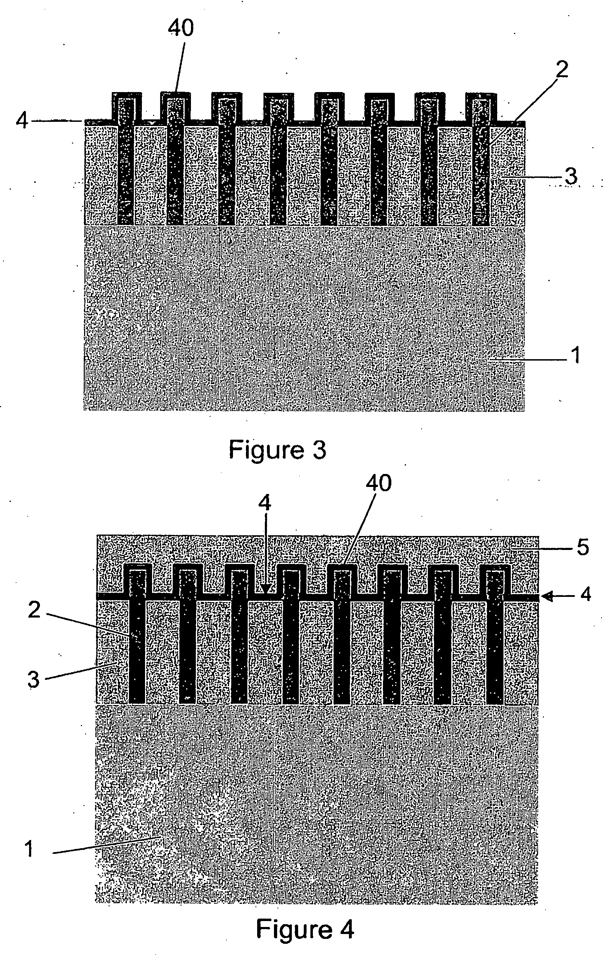

L'étape suivante va être décrite en référence à la figure 3.

Elle consiste à déposer, directement sur le nanofil une couche 4 d'un matériau conducteur électrique. Cette couche est continue.

Cette couche de matériau conducteur électrique peut par exemple se présenter sous la forme de deux couches, l'une de nickel, l'autre d'or, ces couches étant déposées par évaporation sous vide, avec des épaisseurs respectives d'environ 20nm et 200nm. Cette évaporation peut être réalisée par des procédés classiques et par exemple dans un évaporateur assisté par faisceaux d'électrons, ou bien par pulvérisation cathodique.

Dans ces conditions, les couches de nickel et d'or sont déposées à 0,5nm/s sous vide (pression de l'ordre de 10⁻⁷ mbar).

Les bords de la plaquette sont alors délimités par la technique classique dénommée "lift off' qui est notamment décrite dans « S. Wolf et R.N. Tauber, Silicon Processing for the VLSI Era Vol.1 Lattice Press ».

L'étape suivante est illustrée en référence à la figure 4.

Elle consiste à déposer une couche 5 d'un matériau planarisant sur la couche 4 de matériau conducteur électrique.

Le dépôt de cette couche 5 s'effectue de façon similaire à celui de la couche 3 qui a été décrite en référence à la figure 1.

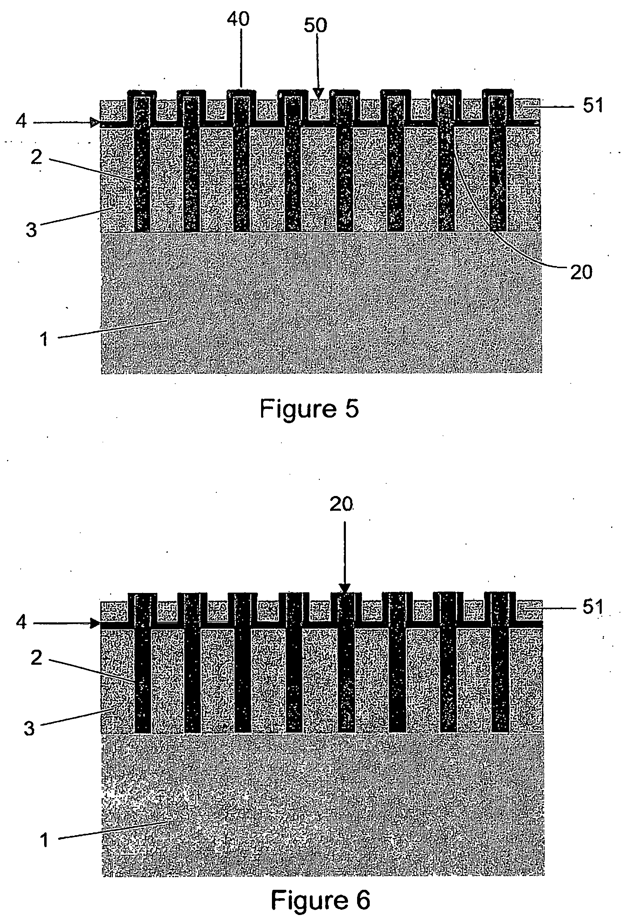

L'étape suivante est illustrée à la figure 5 qui est une étape de gravure de la couche 5 de matériau planarisant.

Cette gravure peut être réalisée grâce au bâti mentionné précédemment avec un plasma d'oxygène.

Les paramètres de la gravure sont choisis de façon à ce que les parties 40 de la couche 4 de matériau conducteur directement en contact avec la face supérieure 20 des nanofils soit apparente. Ainsi, comme l'illustre la figure 5, les parties 40 de la couche 4 dépassent légèrement de la surface 50 de la couche 51 restante.

On comprend ici que la hauteur des nanofils peut être variable. Il suffit d'adapter les paramètres de gravure pour que toutes les parties 40 soient apparentes, la couche 51 gardant une hauteur sensiblement constante.

La figure 6 illustre une autre étape de gravure.

Cette étape consiste à graver la couche 4 de matériau conducteur, de façon à ce que le matériau conducteur présent sur la face supérieure 20 des nanofils soit retiré. En pratique, ceci revient à retirer les parties 40 de la couche 4.

Dans le cas où la couche 4 est formée de deux couches, l'une d'or et l'autre de nickel : pour la couche d'or, la gravure est une gravure humide qui est réalisée avec une solution de type iodure de potassium; pour la couche de nickel, la gravure peut notamment être réalisée avec une solution de peroxydisulfate d'ammonium mélangée avec du FeCl₃ dans les proportions respectives 0,8mol/l et 0,09mol/l.

La gravure se fait de préférence à 50°C et la vitesse de gravure est de l'ordre de 30nm/s pour le nickel, tandis qu'elle est de 20 nm/s pour l'or.

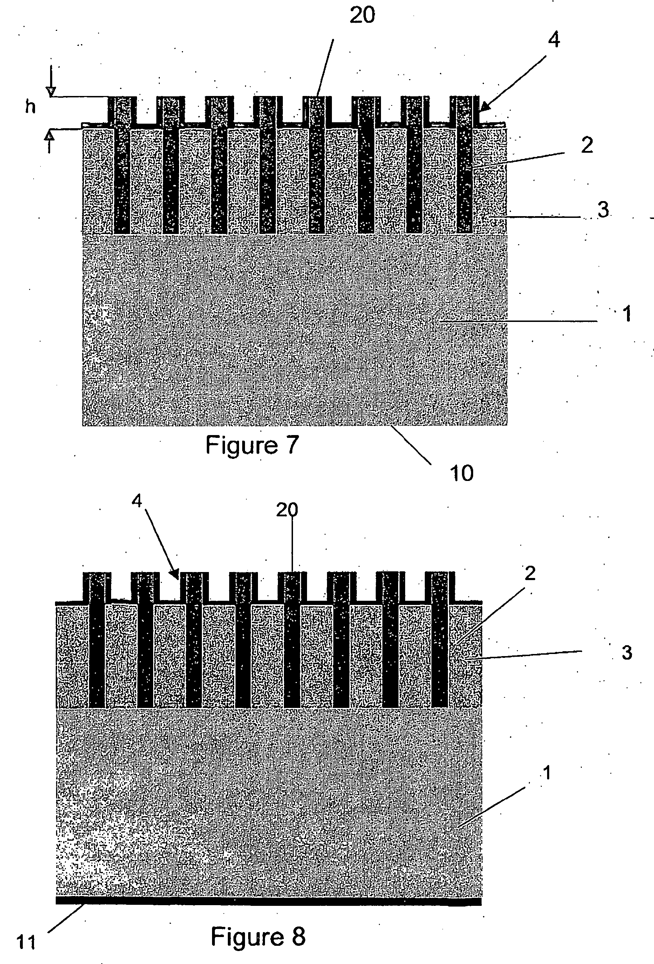

La figure 7 illustre l'étape suivante consistant à complètement retirer la couche 51 de matériau planarisant restant.

Ce retrait est obtenu par gravure avec un plasma d'oxygène.

La figure 7 illustre le résultat obtenu.

Ainsi, à ce stade de la réalisation du dispositif optoélectronique selon l'invention, une des zones de contact électrique est réalisée sur la hauteur h des nanofils. Cette zone de contact prend la forme d'une couche de matériau conducteur électrique qui est formée sur le pourtour des nanofils et qui est en contact direct avec les nanofils. Ceci signifie qu'aucun matériau n'est prévu entre cette couche de matériau conducteur et les nanofils. La couche de matériau conducteur électrique est présente à la fois sur la hauteur h des nanofils et entre les nanofils eux-mêmes. Du fait de la gravure intervenue à l'étape illustrée à la figure 6, la face supérieure 20 des nanofils 2 est découverte.

L'autre zone de contact électrique doit être créée sur la face libre 10 du substrat. La zone de contact sur le substrat 1 porte la référence 11 et elle est illustrée sur la figure 8. Comme indiqué précédemment, le substrat retenu dans l'exemple illustré est un substrat de silicium qui est dopé avec des porteurs de type n.

Le substrat est donc conducteur et permettra d'injecter uniformément le courant dans les nanofils.

Dans l'exemple illustré, il existe une continuité électrique entre le substrat et les nanofils.

De façon classique, si cela est.nécessaire, le dispositif obtenu peut être découpé par sciage en fonction de la taille désirée.

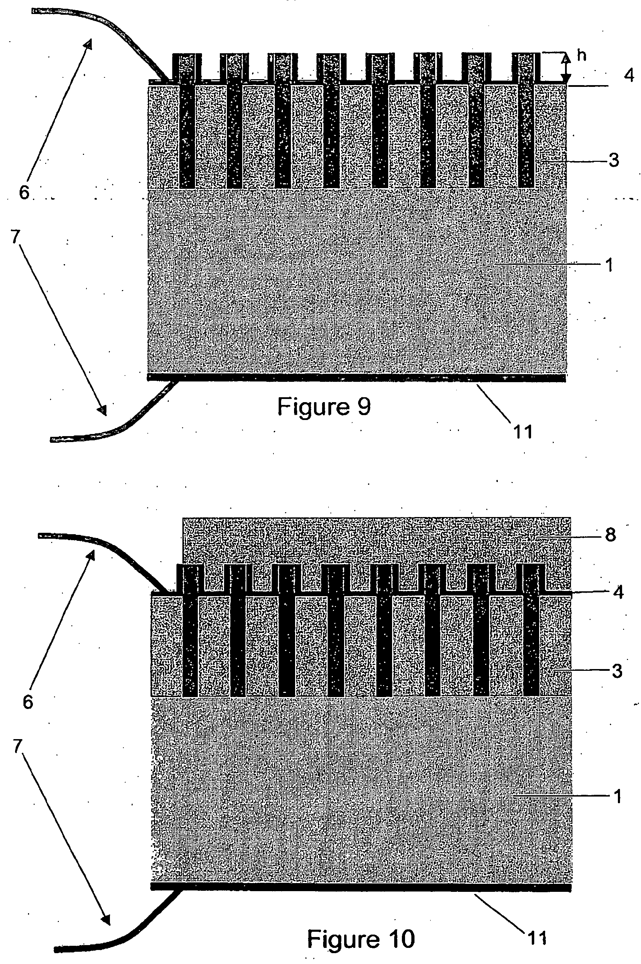

La figure 9 illustre la dernière étape permettant de terminer le dispositif optoélectronique selon l'invention.

Cette étape consiste a souder des fils métalliques 6 et 7 d'une part, au niveau de la couche 4 et d'autre part, au niveau de la zone de contact 11.

En utilisation, c'està-dire lorsqu'un courant électrique est appliqué au dispositif, les nanofils émettent de la lumière, du fait des recombinaisons au niveau de leur jonction pn.

La figure 10 illustre une variante de mise en oeuvre du procédé d'invention, dans laquelle est déposée, à la surface du dispositif, une. couche supplémentaire 8 contenant un matériau dit phosphorescent, par exemple un grenat d'Yttrium aluminium, appelé couramment YAG (Yttrium Aluminium Garnet) dopé cerium. Ce matériau dit phosphorescent va permettre de convertir la lumière quasi-monochromatique issue de la diode, en lumière dite blanche, c'est-à-dire composée d'un spectre large en longueur d'onde.

Il convient de noter que le dispositif optoélectronique selon l'invention présente une structure fonctionnelle axiale, c'est-à-dire que chaque nanofil comporte des zones de type p et de type n qui sont disposées successivement selon l'axe des nanofils. Cette structure diffère des structurés fonctionnelles radiales, dans lesquelles les zones de type p et de type n sont ménagées en périphérie du nanofil. Dans ce cas, les zones de type p et de type n sont disposées successivement dans une direction perpendiculaire à celle de l'axe des nanofils. Le document US-2007/0057248 décrit, par exemple, une telle structure fonctionnelle radiale.

Dans les dispositifs à structure axiale, l'émission de lumière est réalisée à partir de puits quantiques. L'émission de lumière issue de ces puits est anisotrope. Dans les dispositifs à structure axiale, cette émission se couple mieux avec le mode guidé du nanofil, ce qui facilite l'extraction de lumière. Dans le cas de dispositifs à structure radiale, l'émission de lumière se couple difficilement avec les modes guidés des nanofils. La lumière sort directement du nanofil et se retrouve dans le matériau planarisant qui entoure le nanofil ou absorbé par un contact métallique périphérique.

La description qui précède montre que le procédé selon l'invention permet d'obtenir un dispositif optoélectronique à base de semi-conducteurs électroniques de type nanofils, conçus pour émettre un faisceau lumineux en utilisation, sans que soit nécessaire une couche conductrice semi-transparente recouvrant la surface des nanofils.

Au niveau des nanofils, le contact électrique est obtenu par la présence d'un matériau conducteur sur le pourtour des nanofils et en contact direct avec ceux-ci, ce matériau étant prévu au niveau de leur extrémité opposée au substrat. Par ailleurs, la face supérieure des nanofils est complètement découverte. Ceci permet de réaliser un contact, du côté opposé au substrat, sans gêner l'émission de lumière depuis les nanofils.

Par ailleurs, la solution selon l'invention permet d'augmenter la surface de contact du nanofil, dès que la hauteur h de contact est supérieure à la moitié du rayon. En effet, pour un dispositif classique, la surface de contact est égale à π*I²*. *Elle est égale à 2πrh* pour un dispositif selon l'invention.

Ceci entraine deux avantages substantiels :
Il est possible de diminuer la résistance de contact, à dopage de couche constant. Ainsi, les dispositifs pourront fonctionner à une plus faible tension ou consommer moins à une tension constante.

Ceci permet également de diminuer le dopage du nanofil sur la hauteur h destinée à être recouverte par les matériaux conducteurs et ceci, à résistance de contact constante. Ceci permettra de diminuer également l'absorption de lumière par les porteurs libres et donc d'augmenter l'efficacité d'extraction de lumière du dispositif optoélectronique obtenu.

On comprend que dans la description qui précède, le dépôt d'une couche de matériau planarisant peut être remplacé par le dépôt d'une couche d'un matériau remplissant les interstices, suivi d'une étape de planarisation.

Comme cela a été noté précédemment, le procédé selon l'invention permet de réaliser un contact pour tous les nanofils, même s'ils sont de hauteur différente, sans qu'il soit nécessaire de les polir au préalable Enfin, le procédé selon l'invention permet d'obtenir des dispositifs optoélectroniques de type LED, diode laser, ou photo-détecteur.

## Revendications

1. Procédé de réalisation d'un dispositif optoélectronique, à base de semi-conducteurs de type nanofils et présentant une structure fonctionnelle axiale, comprenant les étapes suivantes :
- l'obtention de nanofils (2) sur un substrat (1) au niveau duquel est réalisée une première zone de contact électrique, lesdits nanofils étant susceptibles d'émettre un faisceau lumineux,
- le dépôt d'une couche de matériau (3) pour remplir les interstices entre les nanofils, éventuellement ultérieurement planarisée,
**caractérisé en ce qu'**il comprend des étapes d'obtention d'une couche d'un matériau conducteur électrique (4) sur le pourtour desdits nanofils et en contact direct avec les nanofils, sur une hauteur (h) déterminée et au niveau de leur extrémité opposée audit substrat, ainsi qu'entre lesdits nanofils, la face supérieure (20) des nanofils étant à nu, de manière à former une deuxième zone de contact électrique au niveau des nanofils.

2. Procédé selon la revendication 1, dans lequel les étapes d'obtention d'une couche d'un matériau conducteur électrique (4) consistent en :
- la gravure de ladite couche de matériau (3) pour mettre à nu l'extrémité supérieure des nanofils sur une hauteur (h) déterminée,
- le dépôt d'une couche de matériau conducteur électrique (4) sur ladite hauteur (h) des nanofils,
- le dépôt d'une autre couche d'un matériau (5) pour remplir les interstices entre les nanofils, suivi éventuellement d'une étape de planarisation,
- la gravure de ladite autre couche de matériau (5) pour découvrir la partie supérieure des nanofils,
- la gravure de la couche de matériau conducteur électrique (4) pour mettre à nu la face supérieure (20) des nanofils,
- le retrait du matériau conducteur électrique présent sur la face supérieure (20) des nanofils, et enfin
- le retrait de l'autre couche de matériau (51) encore présente sur le matériau conducteur électrique.

3. Procédé selon l'une des revendications 1 à 2, dans lequel, les nanofils sont dopés avec des porteurs appropriés pour assurer une bonne continuité électrique entre le substrat (1) et les nanofils (2).

4. Procédé selon la revendication 3, dans lequel le dopage des nanofils (2), sur la hauteur (h), est réalisé avec des porteurs de conductivité opposée à celle des porteurs présents dans le reste des nanofils.

5. Procédé selon l'une des revendications 1 à 4, dans lequel le contact entre les nanofils (2) et le substrat (1) est réalisé directement ou indirectement.

6. Procédé selon l'une des revendications 1 à 5, dans lequel des fils métalliques (6, 7) sont fixés au niveau de chacune desdites zones de contact électrique.

7. Procédé selon l'une des revendications 1 à 6 dans lequel une dernière couche de matériau dit phosphorescent (8) est déposée de façon à recouvrir la face supérieure (20) des nanofils.

8. Dispositif optoélectronique comportant au moins un semi-conducteur de type nanofil et présentant une structure fonctionnelle axiale, chaque nanofil présentant une structure de type guide d'ondes, et étant susceptible d'émettre un faisceau lumineux, et deux zones de contact électrique, l'une d'elles étant située sur le pourtour dudit au moins un nanofil (2), en contact direct avec ledit au moins un nanofil et à proximité de l'une de ses extrémités, la face supérieure (20) dudit nanofil ne participant pas au contact électrique.

9. Dispositif optoélectronique selon la revendication 8, dans lequel la zone de contact électrique située sur le pourtour dudit au moins un nanofil est constituée par une couche d'un matériau conducteur électrique (4) qui laisse à découvert la face supérieure (20) du nanofil.

10. Dispositif selon les revendications 8 ou 9, dans lequel ledit au moins un nanofil (2) comprend, dans la zone de contact électrique située sur son pourtour, un dopage réalisé avec des porteurs de conductivité opposée à celle des porteurs présents dans le reste du nanofil.

11. Dispositif selon l'une des revendications 8 à 10, comprenant une couche d'un matériau dit phosphorescent (8) recouvrant la face supérieure (20) dudit au moins un nanofil (2) pour convertir la lumière issue dudit nanofil en lumière dite blanche.

## Patentansprüche

1. Verfahren zum Ausführen einer optoelektronischen Anordnung basierend auf Halbleitern vom Typ Nanodrähte und die eine axiale Funktionsstruktur aufweist, das die folgenden Schritte umfasst:
- Erhalten von Nanodrähten (2) auf einem Substrat (1), an dessen Bereich eine erste elektrische Kontaktzone ausgeführt wird, wobei die Nanodrähte einen Lichtstrahl emittieren können,
- Aufbringen einer Materialschicht (3) zum Füllen der Lücken zwischen den Nanodrähten, die gegebenenfalls anschließend planarisiert wird,
**dadurch gekennzeichnet, dass** es die Schritte zum Erhalten einer Schicht aus einem elektrisch leitfähigen Material (4) auf dem Umfang der Nanodrähte und in direktem Kontakt mit den Nanodrähten über eine bestimmte Höhe (h) und im Bereich ihres dem Substrat entgegengesetzten Endes sowie zwischen den Nanodrähten umfasst, wobei die obere Seite (20) der Nanodrähte freiliegt, derart, dass eine zweite elektrische Kontaktzone im Bereich der Nanodrähte gebildet wird.

2. Verfahren nach Anspruch 1, wobei die Schritte zum Erhalten einer Schicht aus einem elektrisch leitfähigen Material (4) aus Folgendem bestehen:
- Ätzen der Materialschicht (3), um das obere Ende der Nanodrähte über eine bestimmte Höhe (h) freizulegen,
- Aufbringen einer Schicht aus elektrisch leitfähigem Material (4) über die Höhe (h) der Nanodrähte,
- Aufbringen einer anderen Schicht aus einem Material (5) zum Füllen der Lücken zwischen den Nanodrähten, auf das gegebenenfalls ein Schritt zum Planarisieren folgt,
- Ätzen der anderen Schicht aus Material (5), um den oberen Teil der Nanodrähte frei zu machen,
- Ätzen der Schicht aus elektrisch leitfähigem Material (4), um die obere Seite (20) der Nanodrähte freizulegen,
- Wegnahme des elektrisch leitfähigen Materials, das auf der oberen Seite (20) der Nanodrähte vorhanden ist, und schließlich
- Wegnahme der anderen Materialschicht (51), die noch auf dem elektrisch leitfähigen Material vorhanden ist.

3. Verfahren nach einem der Ansprüche 1 bis 2, wobei die Nanodrähte mit zweckmäßigen Ladungsträgern dotiert werden, um einen guten Stromdurchgang zwischen dem Substrat (1) und den Nanodrähten (2) zu gewährleisten.

4. Verfahren nach Anspruch 3, wobei das Dotieren der Nanodrähte (2) über die Höhe (h) mit Ladungsträgern ausgeführt wird, deren Leitfähigkeit derjenigen der Ladungsträger, die im Rest der Nanodrähte vorhanden sind, entgegengesetzt ist.

5. Verfahren nach einem der Ansprüche 1 bis 4, wobei der Kontakt zwischen den Nanodrähten (2) und dem Substrat (1) direkt oder indirekt ausgeführt wird.

6. Verfahren nach einem der Ansprüche 1 bis 5, wobei die Metalldrähte (6, 7) im Bereich von jeder der elektrischen Kontaktzonen befestigt sind.

7. Verfahren nach einem der Ansprüche 1 bis 6, wobei eine letzte Schicht aus sogenanntem phosphoreszierendem Material (8) derart aufgebracht wird, dass sie die obere Seite (20) der Nanodrähte bedeckt.

8. Optoelektronische Anordnung, die mindestens einen Halbleiter vom Typ Nanodraht umfasst, und die eine axiale Funktionsstruktur, wobei jeder Nanodraht eine Struktur vom Typ Wellenleiter aufweist und einen Lichtstrahl emittieren kann, und zwei elektrische Kontaktzonen aufweist, von denen eine sich auf dem Umfang des mindestens einen Nanodrahtes (2) in direktem Kontakt mit dem mindestens einen Nanodraht und in der Nähe von einem seiner Enden befindet, wobei die obere Seite (20) des Nanodrahts nicht am elektrischen Kontakt teilnimmt.

9. Optoelektronische Anordnung nach Anspruch 8, wobei die elektrische Kontaktzone, die sich auf dem Umfang des mindestens einen Nanodrahtes befindet, aus einer Schicht aus einem elektrisch leitfähigen Material (4) besteht, das die obere Seite (20) des Nanodrahtes frei lässt.

10. Anordnung nach Anspruch 8 oder 9, wobei der mindestens eine Nanodraht (2) in der elektrischen Kontaktzone, die sich auf seinem Umfang befindet, eine Dotierung umfasst, die mit Ladungsträgern ausgeführt ist, deren Leitfähigkeit derjenigen der Ladungsträger, die auf dem Rest des Nanodrahts vorhanden sind, entgegengesetzt ist.

11. Anordnung nach einem der Ansprüche 8 bis 10, die eine Schicht aus einem sogenannten phosphoreszierenden Material (8) umfasst, die die obere Seite (20) des mindestens einen Nanodrahts (2) bedeckt, um das von dem Nanodraht stammende Licht in sogenanntes weißes Licht umzuwandeln.

## Claims

1. A process for fabricating an optoelectronic device based on nanowire-type semiconductors having an axial functional structure, comprising the following steps :
- obtaining nanowires (2) on a substrate (1) on which a first electrical contact zone is produced, said nanowires being capable of emitting a light beam; and
- depositing a layer (3) of material in order to fill the interstices between the nanowires, said layer being optionally planarized subsequently,
**characterized in that** it includes steps for obtaining a layer (4) of an electrically conducting material on the periphery of the nanowires (2) and in direct contact with the nanowires, over a defined height (h) thereof and close to their end on the opposite side from said substrate, and also between said nanowires, the upper face (20) of the nanowires being bared, in such a way that a second electrical contact zone is formed on said nanowires.

2. The process according to claim 1, in which the steps for obtaining a layer (4) of an electrically conducting material consist in:
- etching said layer (3) of material so as to bare the upper end of the nanowires over a defined height (h);
- depositing a layer (4) of electrically conducting material over said height (h) of the nanowires;
- depositing another layer (5) of a material in order to fill the interstices between the nanowires, optionally followed by a planarization step;
- etching said other layer (5) of material in order to expose the upper part of the nanowires;
- etching the layer (4) of electrically conducting material in order to bare the upper face (20) of the nanowires;
- removing the electrically conducting material present on the upper face (20) of the nanowires; and finally
- removing the other layer (51) of material still present on the electrically conducting material.

3. The process according to any one claims 1 to 2, in which the nanowires are doped with suitable carriers in order to ensure good electrical continuity between the substrate (1) and the nanowires (2).

4. The process according to claim 3, in which the nanowires (2) are doped over the height (h) with carriers of opposite conductivity to that of the carriers present in the rest of the nanowires.

5. The process according to any one of claims 1 to 4, in which the contact between the nanowires (2) and the substrate (1) is made directly or indirectly.

6. The process according to any one of claims 1 to 5, in which the metal wires (6, 7) are bonded to each of said electrical contact zones.

7. The process according to any one of claims 1 to 6, in which a final layer (8) of phosphorescent material is deposited so as to cover the upper face (20) of the nanowires.

8. An optoelectronic device comprising at least one nanowire-type semiconductor having an axial functional structure, each nanowire having a waveguide-type structure and being capable of emitting a light beam, and two electrical contact zones, one of the zones being located on the periphery of said at least one nanowire (2), in direct contact with said at least one nanowire and close to one of its ends, the upper face (20) of said nanowire not participating in the electrical contact.

9. The optoelectronic device according to claim 8, in which the electrical contact zone located on the periphery of said at least one nanowire is formed by a layer (4) of an electrically conducting material that leaves the upper face (20) of the nanowire exposed.

10. The device according to claim 8 or 9, in which said at least one nanowire (2) is doped in the electrical contact zone located on its periphery with carriers of opposite conductivity to that of the carriers present in the rest of the nanowire.

11. The device according to any one of claims 8 to 10, which includes a layer (8) of a phosphorescent material covering the upper face (20) of said at least one nanowire (2) in order to convert the light emanating from said nanowire into white light.
